# FASCICULE DE BREVET EUROPEEN

(11) **EP 2 408 944 B1**
(45) Date de publication et mention de la délivrance du brevet: **09.01.2013**
(21) Numéro de dépôt: 10709004.5
(22) Date de dépôt: 17.03.2010
(51) Int. Cl.: C23C 14/06, C23C 14/34, C23C 14/58

(54) **PROCEDE DE PREPARATION D'UNE COUCHE MINCE DE THIOSPINELLES**
VERFAHREN ZUR HERSTELLUNG EINES DÜNNEN FILMS VON THIOSPINELLEN
METHOD FOR PREPARING A THIN FILM OF THIOSPINELS

(30) Priorité: 18.03.2009 FR 0951744
(43) Date de publication de la demande: 25.01.2012
(73) Titulaire: Centre National de la Recherche Scientifique, 75016 Paris (FR)
(72) Inventeur: BESLAND, Marie-Paule, F-44700 Orvault (FR); SOUCHIER, Emeline, F-26290 Donzere (FR); CARIO, Laurent, F-44200 Nantes (FR); CORRAZE, Benoît, F-44470 Carquefou (FR); JANOD, Etienne, F-44240 La Chapelle Sur Erdre (FR); MARTIAL, Julie, F-24300 Lussas Et Nontronneau (FR)
(74) Mandataire: Larcher, Dominique
(86) Numéro de dépôt international: PCT/EP2010/053442
(87) Numéro de publication internationale: WO 2010/106093

(56) Documents cités:
- FR-A1- 2 913 806
- QUERE Y ET AL: "A very simple dc sputtering device for chemistry laboratory use" MATERIALS LETTERS, NORTH HOLLAND PUBLISHING COMPANY. AMSTERDAM, NL, vol. 3, no. 9-10, 1 juillet 1985 (1985-07-01), pages 340-343, XP024149945 ISSN: 0167-577X [extrait le 1985-07-01]

## Description

Le domaine de l'invention est celui de la micro-électronique.

Plus précisément, l'invention concerne un procédé de préparation d'une couche mince de composés appartenant à la famille des thiospinelles.

Les inventeurs de la présente Demande ont récemment découvert, tel que décrit dans la Demande de Brevet Français FR 2 913 806, l'existence d'un phénomène de transition résistive non-volatile et réversible induite par pulse électrique entre deux états de résistance (« EPIRS » ou « Electric-Pulse-Induced Resistive Switching) dans une famille de composés à l'état monocristallin et répondant à la formule AM₄X₈, dans laquelle :
- A représente Ga ou Ge ;
- M représente V, Nb, Ta ou Mo; et
- X représente S ou Se.

Ces composés présentent un grand intérêt en microélectronique, du fait de leurs propriétés remarquables.

En effet, ces composés présentent l'avantage de pouvoir faire commuter un élément logique entre deux états de résistance électrique avec de faibles tensions, notamment inférieures à 0,1V. Ces composés sont également particulièrement intéressants puisqu'ils peuvent permettre l'obtention de temps de commutation entre deux états inférieurs à ceux des mémoires de type Flash de l'art antérieur et peuvent augmenter l'intégration, c'est-à-dire augmenter la quantité d'informations stockées par unité de volume.

Ces composés peuvent ainsi être particulièrement utiles, notamment en tant que matériaux actifs dans les mémoires résistives non-volatiles de type RRAM (Resistive Random Access Memory), comme solution alternative aux mémoires de type Flash qui présentent certaines limites.

Or, l'intégration de ces composés dans un dispositif de micro-électronique tel qu'une mémoire de type RRAM, requiert leur dépôt en couche mince.

Il existe à l'heure actuelle de nombreuses techniques permettant l'obtention de couches minces de différents composés telles que des méthodes chimiques, des méthodes en phase vapeur ou encore des méthodes basées sur la pulvérisation cathodique.

Parmi ces techniques, certaines permettent l'obtention de couches minces de composés sous la forme de monocristaux, telles que l'ablation laser (« PLD » « Pulsed Laser Deposition »), l'épitaxie par jet moléculaire (« MBE » « Molecular Beam Epitaxy ») ou des techniques chimiques (type « CSD » « Chemical Solution Deposition » soit une méthode de dépôt de type chimique à partir d'une solution du matériau) à base d'hydrazine. Toutefois ces techniques présentent certains inconvénients. En effet, l'ablation laser (« PLD ») est peu adaptée au milieu industriel, notamment du fait de la faible surface de dépôt obtenue par cette technique. Par ailleurs, il y a très peu de travaux sur l'obtention de couches minces de composés chalcogénures (sulfures ou séléniures) par épitaxie par jet moléculaire (« MBE »). Enfin, l'utilisation d'hydrazine pose des problèmes de sécurité puisqu'il s'agit d'un solvant cancérigène et volatile.

Certaines techniques permettent quant à elles l'obtention de couches minces de composés sous la forme de polycristaux telles que les méthodes basées sur la pulvérisation cathodique, notamment la pulvérisation magnétron.

La pulvérisation magnétron est une technique de pulvérisation cathodique particulière caractérisée par le confinement d'électrons à l'aide d'un champ magnétique près de la surface d'une cible. Cette technique présente l'avantage de permettre l'obtention de vitesses élevées de pulvérisation et donc de permettre l'obtention rapide de couches minces. Elle est par ailleurs très répandue dans le milieu industriel et en particulier compatible avec les procédés de la micro-électronique (S. M. Rossnagel J. Vac. Sci. Technol. A 21.5., 74 (2003) et Allan Matthews J. Vac. Sci. Technol. A 21.5., 2003, p 224).

Toutefois, ces techniques d'obtention de couches minces de composés sous la forme de polycristaux peuvent entraîner une modification de certaines des propriétés des composés par comparaison avec celles observées sur ces composés à l'état monocristallin. Ainsi, en particulier, la pulvérisation magnétron conduit à une couche mince du composé ciblé sous forme de polycristaux présentant des joints de grains qui sont susceptibles de modifier les propriétés électriques du composé ciblé.

À titre d'exemple, les inventeurs ont mis en évidence que la pulvérisation magnétron bien qu'elle permette l'obtention de couches minces de composés particuliers, à savoir de titanate de bismuth substitué au lanthane, sous la forme de polycristaux, entraînait une modification des propriétés électriques de ces composés.

Plus précisément, les inventeurs ont montré qu'une technique incluant notamment une étape de formation d'une couche mince de titanate de bismuth substitué au lanthane par pulvérisation magnétron, suivie d'une étape de recuit de la couche mince ainsi formée permettait l'obtention de couches minces de ces composés sous forme polycristalline, mais entraînait la perte de propriétés ferroélectriques de ces composés (Besland et al., two step reactive magnetron sputtering of blt thin films Journal of Integrated Ferroelectrics (2007) 94-104)

Or, l'existence du phénomène de transition résistive non-volatile et réversible induite par pulse électrique entre deux états de résistance (« EPIRS ») mis en évidence par les inventeurs dans les composés répondant à la formule AM₄X₈ à l'état monocristallin, est vraisemblablement relié à la microstructure cristalline particulière de ces composés.

L'objectif de l'invention est donc de pouvoir disposer d'un procédé qui permette l'obtention de couches minces de composés répondant à la formule AM₄X₈ tout en conservant les propriétés de ces composés et notamment l'existence du phénomène de transition résistive non-volatile et réversible induite par pulse électrique entre deux états de résistance (« EPIRS »).

Les inventeurs ont découvert de manière surprenante, qu'une couche mince polycristalline de composés répondant à la formule AM₄X₈ obtenue par une technique particulière basée sur la pulvérisation magnétron, présente des propriétés structurales et physiques similaires à celles de ces composés sous forme monocristalline. En particulier, les inventeurs ont mis en évidence sur ces couches minces que la présence de joints de grains n'empêche pas d'observer le phénomène de transition résistive non-volatile et réversible induite par pulse électrique entre deux états de résistance (« EPIRS ») découvert précédemment, par les inventeurs sur ces composés à l'état monocristallin (tel que décrit dans la demande de Brevet Français FR 2 913 806). Ce résultat est remarquable, en raison de la forte modification des propriétés électriques observée généralement en présence de joints de grains.

Ainsi, les inventeurs ont maintenant mis au point un procédé permettant l'obtention de couches minces de composés répondant à la formule AM₄X₈ et qui présentent ledit phénomène de transition résistive non-volatile et réversible induite par pulse électrique entre deux états de résistance (« EPIRS »).

Selon un premier aspect, l'invention concerne un procédé de préparation d'une couche mince d'au moins un composé répondant à la formule AM₄X₈, dans laquelle :
- A représente Ga ou Ge ;
- M représente V, Nb, Ta ou Mo; et
- X représente S ou Se ;
ledit procédé comprenant les étapes suivantes :
i) une étape de formation d'une couche mince d'au moins un composé répondant à la formule AM₄X₈ par pulvérisation magnétron d'une cible comprenant au moins un composé répondant à ladite formule AM₄X₈, dans une atmosphère comprenant au moins un gaz inerte ; et
ii) une étape de recuit de la couche mince formée à l'étape i) par traitement thermique ;
dans lequel l'étape i) et/ou l'étape ii) sont mises en oeuvre en présence de soufre lorsque X représente S ou en présence de sélénium lorsque X représente Se.

La technique de pulvérisation magnétron (« Physical Vapor Déposition » ou PVD) est une technique de pulvérisation cathodique particulière ; le principe de la pulvérisation cathodique étant basé sur l'établissement d'une décharge électrique entre deux électrodes conductrices placées dans une enceinte dans laquelle règne une pression réduite de gaz inerte et éventuellement en outre d'un réactif (gaz qui intervient dans la formation de la couche mince), entraînant l'apparition à l'anode d'une couche mince du composé constituant l'électrode antagoniste.

Ainsi, on entend par « pulvérisation magnétron » au sens de la présente invention la technique de pulvérisation cathodique consistant à confiner des électrons à l'aide d'un champ magnétique près de la surface d'une cible dans une enceinte où règne une pression réduite de gaz inerte et éventuellement en outre d'un réactif (tel qu'en l'espèce un gaz précurseur de soufre ou de sélénium). Par superposition au champ électrique d'un champ magnétique perpendiculaire, les trajectoires des électrons s'enroulent autour des lignes de champs magnétiques, augmentant les chances d'ioniser le gaz au voisinage de la cathode. Dans des systèmes de pulvérisation magnétron, le champ magnétique augmente la densité du plasma, ce qui a pour conséquence une augmentation de la densité du courant sur la cathode.

Dans l'étape i) du procédé selon l'invention, ladite cible est placée dans une atmosphère comprenant au moins un gaz inerte dans une enceinte, ladite enceinte étant apte à mettre en oeuvre la pulvérisation magnétron.

Il existe des variantes de la technique de pulvérisation magnétron telles que la pulvérisation magnétron ionisé et la pulvérisation magnétron pulsé. Ces deux variantes peuvent être utilisées dans le procédé selon l'invention.

Ainsi, dans le procédé selon l'invention, la pulvérisation magnétron peut être choisie parmi la pulvérisation magnétron ionisé et la pulvérisation magnétron pulsé. Ces deux variantes présentent l'avantage d'avoir un plus grand taux d'espèces ionisées et donc d'avoir un plasma plus dense et plus efficace, donnant des vitesses de dépôt plus élevées ou encore permettant le remplissage de motifs en creux sur un substrat. Toutefois, ces deux variantes requièrent une grande optimisation afin d'obtenir des couches minces de composés sous forme cristalline. En effet, sans une importante optimisation, ces deux variantes ont tendance à amorphiser le dépôt et peuvent avoir tendance à conduire à l'obtention de couches minces de matériaux amorphes, et ce même après l'étape de recuit, étape ii) du procédé selon l'invention.

La pulvérisation magnétron présente l'avantage de permettre l'obtention de grandes vitesses de pulvérisation, avec en général, une diminution de la température du substrat (S. M. Rossnagel J. Vac. Sci. Technol. A 21.5., 74, 2003).

La présence de gaz inerte dans une enceinte permet d'obtenir un rendement de pulvérisation magnétron correct, sans incorporation du gaz inerte dans la couche mince formée.

Dans le procédé selon l'invention, ledit gaz inerte peut être choisi parmi l'hélium, le néon, l'argon, le krypton, le xénon, de préférence l'argon.

L'utilisation d'argon dans le procédé selon l'invention présente l'avantage de donner des rendements satisfaisants de pulvérisation magnétron, sans incorporation d'argon dans la couche mince obtenue et tout en étant peu onéreux.

Dans le procédé selon l'invention, l'étape i) et/ou l'étape ii) peuvent être mises en oeuvre en présence de soufre lorsque X représente S ou en présence de sélénium lorsque X représente Se, ledit soufre ou ledit sélénium pouvant être présent sous différentes formes à savoir native (soufre ou sélénium élémentaire) ou sous forme d'un gaz précurseur de soufre ou d'un gaz précurseur de sélénium, respectivement.

La mise en oeuvre de l'étape i) et/ou l'étape ii) en présence de soufre lorsque X représente S, contribue à prévenir la sous-stoechiométrie en soufre dans la couche mince de composés obtenue, ladite sous-stoechiométrie étant liée à la grande volatilité du soufre.

De même, la mise en oeuvre de l'étape i) et/ou l'étape ii) en présence de sélénium lorsque X représente Se, contribue à prévenir la sous-stoechiométrie en sélénium dans la couche mince de composés obtenue, ladite sous-stoechiométrie étant liée à la volatilité du sélénium.

Ainsi, selon un mode de réalisation particulier du procédé selon l'invention, l'étape i) et/ou l'étape ii) peuvent être dans une atmosphère comprenant au moins un gaz précurseur de soufre lorsque X représente S ou dans une atmosphère comprenant au moins un gaz précurseur de sélénium lorsque X représente Se.

Ledit gaz précurseur de soufre peut être choisi parmi le sulfure d'hydrogène (H₂S), le disulfure de carbone (CS₂), en particulier le sulfure d'hydrogène.

Ledit gaz précurseur de sélénium peut être notamment le séléniure d'hydrogène (H₂Se).

Le sulfure d'hydrogène présente l'avantage d'être bien adapté à une utilisation en milieu industriel. En effet, le disulfure de carbone est moins adapté à une utilisation en milieu industriel puisqu'il requiert des mesures importantes de sécurité.

Selon un mode de réalisation particulier du procédé selon l'invention, l'étape i) et/ou l'étape ii) peuvent être mises en oeuvre:
- sous flux d'un gaz précurseur de soufre ou dans une atmosphère saturée en soufre lorsque X représente S ; ou
- sous flux d'un gaz précurseur de sélénium ou dans une atmosphère saturée en sélénium lorsque X représente Se.

La mise en oeuvre de l'étape i) et/ou l'étape ii):
- sous flux d'un gaz précurseur de soufre ou dans une atmosphère saturée en soufre lorsque X représente S ; ou
- sous flux d'un gaz précurseur de sélénium ou dans une atmosphère saturée en sélénium lorsque X représente Se ;
présente l'avantage d'optimiser le rétablissement de la stoechiométrie en soufre ou en sélénium du composé ciblé.

L'atmosphère saturée en soufre peut être obtenue soit grâce à un gaz précurseur de soufre soit à partir de soufre élémentaire à l'état gazeux, de préférence à partir de soufre élémentaire à l'état gazeux.

De même, l'atmosphère saturée en sélénium peut être obtenue soit grâce à un gaz précurseur de sélénium, soit à partir de sélénium élémentaire à l'état gazeux, de préférence à partir de sélénium élémentaire à l'état gazeux.

L'atmosphère saturée en soufre ou en sélénium présente un avantage en terme de sécurité et permet d'optimiser le rétablissement de la stoechiométrie en soufre ou en sélénium du composé ciblé.

Le flux de gaz précurseur de soufre ou de gaz précurseur de sélénium présente l'avantage d'être plus facile à implémenter en milieu industriel.

L'utilisation du soufre élémentaire et du sélénium élémentaire présentent l'avantage d'être plus pratique.

Selon un mode de réalisation particulier du procédé selon l'invention, l'étape ii) peut être mise en oeuvre à une température comprise entre 200 et 850 °C, en particulier entre 400 et 750 °C et tout particulièrement entre 450 et 650 °C.

La mise en oeuvre de l'étape ii) du procédé selon l'invention à une température comprise entre 450 et 650 °C présente l'avantage d'être aisément reproductible.

Selon un mode de réalisation particulier du procédé selon l'invention, l'étape ii) peut être mise en oeuvre pendant une durée comprise entre 1 minute et 200 heures, en particulier entre 10 minutes et 48 heures et tout particulièrement entre 30 minutes et 120 minutes.

La mise en oeuvre de l'étape ii) du procédé selon l'invention pendant une durée comprise entre 30 minutes et 120 minutes présente l'avantage d'être compatible avec les procédés usuels de la micro-électronique.

Selon un mode de réalisation particulier du procédé selon l'invention, l'étape i) peut être mise en oeuvre dans une atmosphère dont la pression de gaz totale est comprise entre 133 et 13300 mPa (1 et 100 mTorr), en particulier entre 1330 et 10700 mPa (10 et 80 mTorr) et tout particulièrement entre 5330 et 8000 mPa (40 et 60 mTorr).

La mise en oeuvre de l'étape i) du procédé selon l'invention dans une atmosphère dont la pression totale de gaz est comprise entre 40 et 60 mTorr présente l'avantage de conserver au mieux la stoechiométrie du composé dans la couche mince obtenue.

Selon un mode de réalisation particulier du procédé selon l'invention, l'étape i) peut être mise en oeuvre en présence d'un générateur de puissance électrique fournissant une puissance comprise entre 0,1 mW/cm² et 20 W/cm², en particulier entre 0,5 et 2,5 W/cm² et tout particulièrement entre 0,5 et 1,5 W/cm² de surface de la cible.

La mise en oeuvre de l'étape i) du procédé selon l'invention en présence d'un générateur de puissance électrique fournissant une puissance comprise entre 0,5 et 1,5 W/cm² de surface de la cible présente l'avantage de conserver au mieux la stoechiométrie du composé dans la couche mince obtenue.

La distance cible-substrat (sur laquelle la couche mince est déposée) pourra varier en fonction de la cible et du volume de l'enceinte. À titre d'exemple, la distance cible-substrat pourra être comprise entre 2 et 7 cm avec comme cible le composé GaV₄S₈, dans une enceinte d'un volume de 0.025 m³ (par exemple, 25cmx25cmx40cm) et avec une surface de cible 78.5 cm².

Selon un mode de réalisation particulier du procédé selon l'invention, ladite cible peut comprendre au moins un composé répondant à la formule AM₄S₈ dans laquelle :
- A représente Ga ou Ge ;
- M représente V, Nb, Ta ou Mo;

en particulier au moins un composé répondant à la formule GaV₄S₈.

Selon un mode de réalisation particulier du procédé selon l'invention, ladite étape i) peut être une étape de formation, sur un substrat, d'une couche mince d'au moins un composé répondant à la formule AM₄X₈ par pulvérisation magnétron d'une cible comprenant au moins un composé répondant à ladite formule AM₄X₈, dans une atmosphère comprenant au moins un gaz inerte.

En particulier, ledit substrat peut être choisi parmi les substrats à base de silicium et en particulier les substrats comprenant une couche de silice sur une couche de silicium, les substrats comprenant une couche de métal sur une couche de silicium ou encore les substrats comprenant une couche de métal sur une couche de silice, ladite couche de silice étant sur une couche de silicium.

La présente invention concerne également un dispositif comprenant un substrat recouvert au moins partiellement d'une couche mince d'au moins un composé répondant à la formule AM₄X₈ dans laquelle :
AM₄X₈, dans laquelle :
   - A représente Ga ou Ge ;
   - M représente V, Nb, Ta ou Mo; et
   - X représente S ou Se ;
ladite couche mince étant susceptible d'être obtenue par le procédé selon l'invention.

La présente invention concerne également une mémoire résistive non-volatile de type RRAM (Resistive Random Access Memory) comprenant un dispositif selon l'invention.

La présente invention concerne également un fusible comprenant un dispositif selon l'invention.

La présente invention concerne également un commutateur comprenant un dispositif selon l'invention.

D'autres caractéristiques et avantages de l'invention apparaîtront au regard des exemples qui suivent.

Ces exemples sont donnés à titre illustratif et non limitatif.

La figure 1(a) illustre les diagrammes obtenus par diffraction de rayons X de la couche mince du composé GaV₄S₈, formée à l'étape i) du procédé selon l'invention (x), de la couche mince recuite du composé GaV₄S₈, obtenue à l'étape ii) du procédé selon l'invention (y), en comparaison avec le diagramme de la poudre polycristalline du composé GaV₄S₈ (z).

La Figure 1(b) est une image obtenue par microscopie électronique à balayage d'une coupe transversale de la couche mince du composé GaV₄S₈, formée à l'étape i) du procédé selon l'invention.

La Figure 1(c) est une image obtenue par microscopie électronique à balayage d'une vue en plan de la surface de la couche mince après recuit du composé GaV₄S₈, obtenue à l'étape ii) du procédé selon l'invention (y).

La Figure 1(d) est une image obtenue par microscopie électronique à balayage d'une coupe transversale de la couche mince après recuit du composé GaV₄S₈, obtenue à l'étape ii) du procédé selon l'invention (y).

La Figure 2(a) représente la comparaison du spectre de la bande de valence du composé GaV₄S₈ sous forme de monocristaux (w), avec celui de la couche mince du composé GaV₄S₈, formée à l'étape i) du procédé selon l'invention (x) et celui de la couche mince après recuit du composé GaV₄S₈, obtenue à l'étape ii) du procédé selon l'invention (y).

La Figure 2(b) représente la susceptibilité magnétique en fonction de la température, du composé GaV₄S₈ sous forme polycristalline (z), de la couche mince après recuit du composé GaV₄S₈, obtenue à l'étape ii) du procédé selon l'invention (y).

La Figure 3 représente le phénomène de transition résistive non-volatile et réversible induite par pulse électrique entre deux états de résistance (« EPIRS » ou « Electric-Pulse-Induced Resistive Switching) mesuré sur une couche mince recuite du composé GaV₄S₈, obtenue à l'étape ii) du procédé selon l'invention (y) à 300K avec des pulses de 10 µs pour des tensions de plus ou moins 2,5V.

### EXEMPLES

### 1. Exemple 1 : Procédé de préparation d'une couche mince du composé GaV₄S₈ selon l'invention

Etape i) : Les couches minces du composé GaV₄S₈ ont été obtenues par pulvérisation cathodique magnétron RF, en plasma d'Argon à partir d'une cible stoechiométrique du composé.

La chambre de dépôt se compose d'une cathode magnétron de 50 mm de diamètre, équipée d'une cible du matériau de densité 90-95% par rapport à la densité théorique.

La cible a été obtenue par SPS (« Spark Plasma Sintering » aussi connue sous l'acronyme FAST pour « Field Activated Sintering Technique ») qui est une technique de frittage flash à haute température et forte pression, permettant d'obtenir une cible de densité élevée sans chauffage prolongé à une température inférieure à la température de décomposition du matériau (soit inférieure à 800°C). Les films ont été déposés sur substrat silicium ou substrat de silice sur silicium, ou sur une couche de métal sur une couche de silicium ou encore sur une couche de métal sur une couche de silice, ladite couche de silice étant sur une couche de silicium.

Le substrat a été laissé au potentiel flottant, soit sans aucune connexion électrique à la masse. Les dépôts ont été réalisés sans chauffage de l'échantillon, dans une gamme de pression allant de 5330 à 10700 mPa (40 à 80 mTorr), pour un flux de gaz argon fixé à 100 sccm et une puissance RF injectée au niveau de la cible fixée entre 0.5 et 1.5 W/cm².

Les couches minces du composé GaV₄S₈ obtenues après l'étape i) du procédé selon l'invention (x), d'épaisseur comprise entre 100 nm et 2µm sont amorphes et déficitaires en soufre, soit un rapport S/V entre 1.1 et 1.5, comparé au rapport S/V =2 attendu, avec un rapport stoechiométrique des autres éléments, soit Ga:V = 1:4, tels que déterminés par EDS (tel que décrit dans l'exemple 2).

Etape ii) Après dépôt, les couches minces formées à l'étape i) du procédé selon l'invention, ont été soumises à un recuit sous atmosphère saturée en soufre (gaz précurseur H₂S ou soufre élémentaire permettant d'avoir un apport de soufre lors du recuit) à une température comprise entre 500 et 600°C, pendant une durée comprise entre 30 minutes et 120 minutes.

Après cette étape ii), la couche mince, selon l'invention (y), présente la bonne composition chimique, soit GaV₄S₈ et est parfaitement cristallisée, telle que contrôlé par diffraction des Rayons X, avec un diagramme de diffraction similaire à celui du composé GaV₄S₈ sous forme polycristalline (z)

### II. Exemple 2: caractérisation des couches minces obtenues selon le procédé selon l'invention

Les couches minces obtenues selon le procédé de l'invention avec le protocole expérimental décrit à l'exemple 1 ont été analysés.

### II.1 Analyse par spectroscopie de rayons X en dispersion d'énergie (EDS)

L'analyse par spectroscopie X en dispersion d'énergie (EDS) a révélé que la couche mince du composé GaV₄S₈, formée à l'étape i) du procédé selon l'invention est déficiente en soufre, si cette étape i) n'a pas été mise en oeuvre en présence de soufre.

Le fait que l'étape i) et/ou l'étape ii) soit mise en oeuvre en présence de soufre permet de rétablir la stoechiométrie en soufre du composé GaV₄S₈.

### II.2 Analyse par diffraction de rayons X

Les couches minces obtenues à l'étape i) et ii) du procédé selon l'invention selon le protocole expérimental décrit à l'exemple 1, ont été analysées par diffraction de rayons X et les diagrammes ainsi obtenus ont été comparés au diagramme de la poudre polycristalline du composé GaV₄S₈ (z).

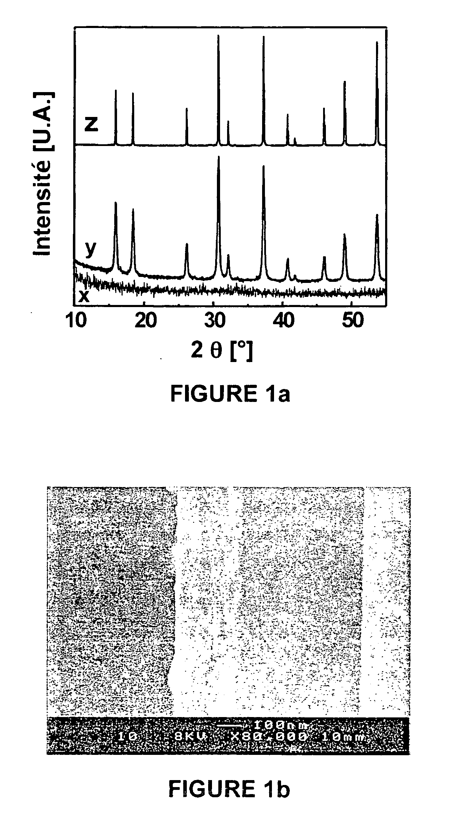

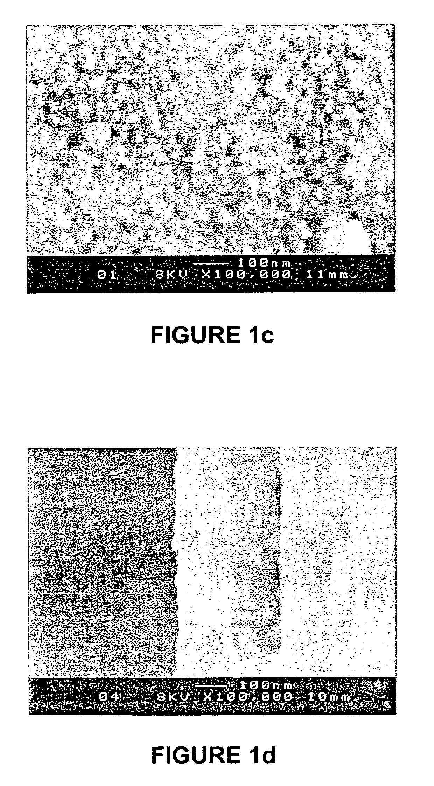

Comme le montre la Figure 1(a), la couche mince du composé GaV₄S₈, formée à l'étape i) du procédé selon l'invention (x) présente une structure amorphe.

Au contraire, la couche mince après recuit du composé GaV₄S₈, obtenue à l'étape ii) du procédé selon l'invention (y) présente un diagramme de diffraction de rayons X similaire à celui du profil de la poudre polycristalline du composé GaV₄S₈ (z).

### II.3 Analyse par microscopie électronique à balayage

Les couches minces obtenues à l'étape i) et ii) du procédé selon l'invention selon le protocole expérimental décrit à l'exemple 1, ont été analysées par microscopie électronique à balayage (Figures 1(b)(c)(d)).

Comme le montre la Figure 1(b), la couche mince du composé GaV₄S₈, formée à l'étape i) du procédé selon l'invention présente une morphologie granulaire ou en colonne.

La couche mince du composé GaV₄S₈, formée à l'étape ii) du procédé selon l'invention présente une morphologie granulaire comprenant des grains de 30 nm (Figures 1(c)(d)). Cette taille de grains est en accord avec la taille des cristallites déterminée par un affinement selon la technique de Rietveld (Rietveld H. M. Acta Crist. 1967, 22, 151. Rietveld H. M. J. Appl. Cryst. 1969, 2, 65.) connue de l'Homme de l'art.

### II.4 Analyse par spectroscopie de photoélectrons X (XPS)

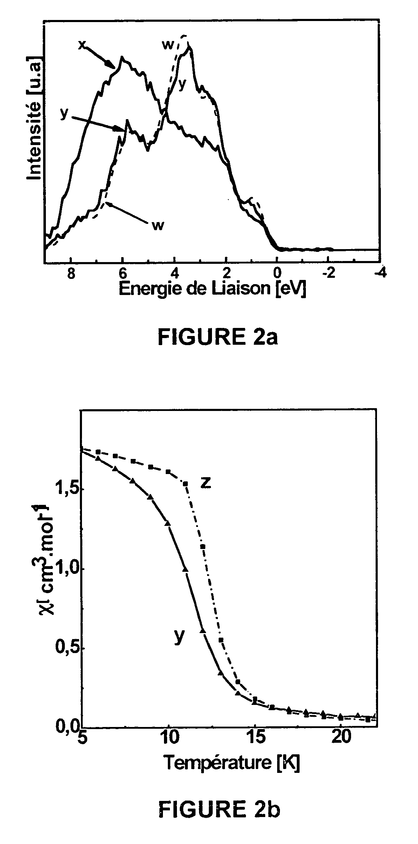

La spectroscopie de photoélectrons a été utilisée pour analyser la composition chimique et la bande de valence du composé GaV₄S₈ sous forme de monocristaux (w), de la couche mince du composé GaV₄S₈, formée à l'étape i) du procédé selon l'invention (x), de la couche mince après recuit du composé GaV₄S₈, obtenue à l'étape ii) du procédé selon l'invention (y) (Figure 2(a)).

Comme le montre la Figure 2(a), la couche mince du composé GaV₄S₈, formée à l'étape i) du procédé selon l'invention (x) présente un spectre de la bande de valence très différent de celui du composé GaV₄S₈ sous forme de monocristaux (w).

Au contraire, la couche mince recuite du composé GaV₄S₈, obtenue à l'étape ii) du procédé selon l'invention (y) présente un spectre de la bande de valence très similaire à celui du composé GaV₄S₈ sous forme de monocristaux (w).

### II.5 Analyse par mesure magnétique

La susceptibilité magnétique en fonction de la température, du composé GaV₄S₈ sous forme polycristalline (z) et de la couche mince recuite du composé GaV₄S₈, obtenue à l'étape ii) du procédé selon l'invention (y) a été analysée avec un champ appliqué de 0.1 TerPa (1000 Gauss) (Figure 2(b)).

Comme le montre la Figure 2(b), la transition ferromagnétique apparaît à la même température pour le composé GaV₄S₈ sous forme polycristalline (z) et la couche mince recuite du composé GaV₄S₈, obtenue à l'étape ii) du procédé selon l'invention (y).

### II.6 Conclusions

L'ensemble de ces analyses décrites ci-dessus (II.1 à II.5) montre que la couche mince du composé GaV₄S₈ obtenue selon le procédé selon l'invention présente les mêmes propriétés électroniques que le composé GaV₄S₈ sous forme de monocristaux.

### III. Exemple 3 : Mise en évidence du phénomène de transition résistive non-volatile et réversible induite par pulse électrique entre deux états de résistance (« EPIRS ») dans les couches minces obtenues selon le procédé selon l'invention

Les couches minces obtenues selon le procédé de l'invention avec le protocole expérimental décrit à l'exemple 1 ont été analysées par rapport au phénomène de transition résistive non-volatile et réversible induite par pulse électrique entre deux états de résistance (« EPIRS »).

Les tests ont été réalisés sur des structures du type Au/GaV₄S₈/Au/Si dans lesquelles une couche mince du composé GaV₄S₈ obtenue selon le procédé selon l'invention recouvre un substrat comprenant une couche d'or sur un substrat de silicium ou sur une couche de silice sur substrat silicium ladite couche mince étant elle-même recouverte d'une couche d'or.

Le dispositif consiste en deux points de contact de part et d'autre de la couche mince du composé GaV₄S₈, à savoir dans les couches d'or.

La résistance de la couche mince du composé GaV₄S₈ a été mesurée en fonction de la température, avec un faible niveau de tension (10⁻² à 10⁻⁵ V) dans l'état initial de haute résistance et dans l'état de basse résistance, après transition résistive. A 300 K, le rapport entre les résistances des niveaux haut et bas est de l'ordre de 10 (Rₕₐᵤₜ= 100 □ et R_{bas} = 10 □), soit potentiellement une variation de 90 % du niveau de résistance, ce qui est particulièrement adapté aux applications en microélectronique.

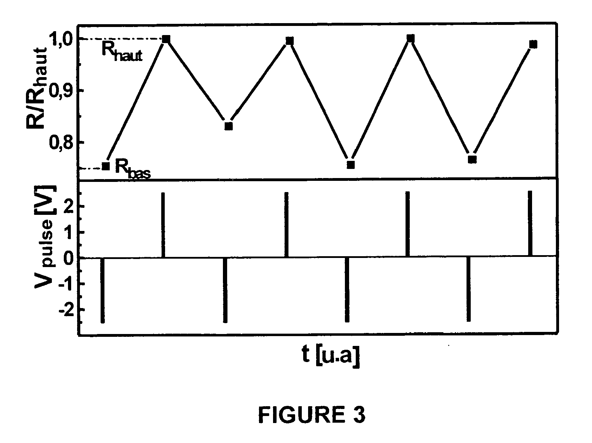

Des pulses de +2,5V et -2,5V d'une durée de 10 µs ont été appliqués alternativement au dispositif à 300K et la résistance de la couche mince a été mesurée après chaque pulse avec une tension de 10⁻³V. Comme le montre la Figure 3, une variation non-volatile de la résistance a été mesurée après chaque pulse de tension (positive ou négative). Une variation relative de la résistance ((Rₕₐᵤₜ-R_{bas})/Rₕₐᵤₜ) d'environ 25 % a ainsi pu être observée.

Pour des pulses d'une durée de 25 ms et pour des tensions moins élevées de +1,5V et -1,5V l'effet est également observé. Ainsi 300 cycles entre les deux états de résistance électrique ont pu être observés sans effet de fatigue du dispositif.

L'ensemble de ces données expérimentales montrent clairement que les couches minces du composé GaV₄S₈ obtenues selon le procédé selon l'invention présentent le même phénomène de transition résistive non-volatile et réversible induite par pulse électrique entre deux états de résistance (« EPIRS ») que le composé GaV₄S₈ sous forme monoctristalline (w).

Le procédé selon l'invention permet donc d'obtenir des couches minces des composés répondant à la formule AM₄X₈, en particulier du composé GaV₄S₈ qui présentent les mêmes propriétés structurales et physiques et notamment le même phénomène de transition résistive non-volatile et réversible induite par pulse électrique entre deux états de résistance (« EPIRS ») que le composé GaV₄S₈ sous forme de monocristaux.

Le procédé selon l'invention est donc particulièrement utile pour l'obtention de couches minces de composés répondant à la formule AM₄X₈, qui pourront avoir des applications en microélectronique, notamment dans les mémoires de type « RRAM ».

## Revendications

1. Procédé de préparation d'une couche mince d'au moins un composé répondant à la formule AM₄X₈, dans laquelle :
- A représente Ga ou Ge ;
- M représente V, Nb, Ta ou Mo; et
- X représente S ou Se ;
ledit procédé comprenant les étapes suivantes :
i) une étape de formation d'une couche mince d'au moins un composé répondant à la formule AM₄X₈ par pulvérisation magnétron d'une cible comprenant au moins un composé répondant à ladite formule AM₄X₈, dans une atmosphère comprenant au moins un gaz inerte ; et
ii) une étape de recuit de la couche mince formée à l'étape i) par traitement thermique ;
dans lequel l'étape i) et/ou l'étape ii) sont mises en oeuvre en présence de soufre lorsque X représente S ou en présence de sélénium lorsque X représente Se.

2. Procédé selon la revendication 1, **caractérisé en ce que** l'étape i) et/ou l'étape ii) sont mises en oeuvre dans une atmosphère comprenant au moins un gaz précurseur de soufre lorsque X représente S ou dans une atmosphère comprenant au moins un gaz précurseur de sélénium lorsque X représente Se.

3. Procédé selon la revendication 1, **caractérisé en ce que** l'étape i) et/ou l'étape ii) sont mises en oeuvre:
- sous flux d'un gaz précurseur de soufre ou dans une atmosphère saturée en soufre lorsque X représente S ; ou
- sous flux d'un gaz précurseur de sélénium ou dans une atmosphère saturée en sélénium lorsque X représente Se.

4. Procédé selon l'une quelconque des revendications 1 à 3, **caractérisé en ce que** l'étape ii) est mise en oeuvre à une température comprise entre 200 et 850 °C, en particulier entre 400 et 750 °C et tout particulièrement entre 450 et 650 °C.

5. Procédé selon l'une quelconque des revendications 1 à 4, **caractérisé en ce que** l'étape ii) est mise en oeuvre pendant une durée comprise entre 1 minute et 200 heures, en particulier entre 10 minutes et 48 heures et tout particulièrement entre 30 minutes et 120 minutes.

6. Procédé selon l'une quelconque des revendications 1 à 5, **caractérisé en ce que** l'étape i) est mise en oeuvre dans une atmosphère dont la pression de gaz totale est comprise entre 133 et 13300 mPa (1 et 100 mTorr), en particulier entre 1330 et 10700 mPa (10 et 80 mTorr) et tout particulièrement entre 5330 et 8000 mPa (40 et 60 mTorr).

7. Procédé selon l'une quelconque des revendications 1 à 6, **caractérisé en ce que** l'étape i) est mise en oeuvre en présence d'un générateur de puissance électrique fournissant une puissance comprise entre 0,1 mW/cm² et 20 W/cm², en particulier entre 0,5 et 2,5 W/cm² et tout particulièrement entre 0,5 et 1,5 W/cm² de surface de la cible.

8. Procédé selon l'une quelconque des revendications 1 à 7, **caractérisé en ce que** ladite cible comprend au moins un composé répondant à la formule AM₄S₈ dans laquelle :
- A représente Ga ou Ge ;
- M représente V, Nb, Ta ou Mo;
en particulier au moins un composé répondant à la formule GaV₄S₈.

## Claims

1. Process for the preparation of a thin layer of at least one compound having the formula AM₄X₈ wherein:
- A represents Ga or Ge;
- M represents V, Nb, Ta or Mo; and
- X represents S or Se;
said process comprising the following steps:
i) a step of forming a thin layer of at least one compound having the formula AM₄X₈ by magnetron sputtering of a target comprising at least one compound having said formula AM₄X₈, in an atmosphere comprising at least one inert gas; and
ii) a step of annealing the thin layer formed in step i) by heat treatment;
wherein step i) and/or step ii) is/are carried out in the presence of sulfur when X represents S or in the presence of selenium when X represents Se.

2. Process according to claim 1, **characterised in that** step i) and/or step ii) is/are carried out in an atmosphere comprising at least one precursor gas for sulfur when X represents S or in an atmosphere comprising at least one precursor gas for selenium when X represents Se.

3. Process according to claim 1, **characterised in that** step i) and/or step ii) is/are carried out:
- under a stream of a precursor gas for sulfur or in an atmosphere saturated with sulfur when X represents S; or
- under a stream of a precursor gas for selenium or in an atmosphere saturated with selenium when X represents Se.

4. Process according to any one of claims 1 to 3, **characterised in that** step ii) is carried out at a temperature of from 200 to 850°C, in particular from 400 to 750°C and most particularly from 450 to 650°C.

5. Process according to any one of claims 1 to 4, **characterised in that** step ii) is carried out for a period of time of from 1 minute to 200 hours, in particular from 10 minutes to 48 hours and most particularly from 30 minutes to 120 minutes.

6. Process according to any one of claims 1 to 5, **characterised in that** step i) is carried out in an atmosphere in which the total gas pressure is from 133 to 13,300 mPa (from 1 to 100 mTorr), in particular from 1330 to 10,700 mPa (from 10 to 80 mTorr) and most particularly from 5330 to 8000 mPa (from 40 to 60 mTorr).

7. Process according to any one of claims 1 to 6, **characterised in that** step i) is carried out in the presence of an electrical power generator that delivers a power of from 0.1 mW/cm² to 20 W/cm², in particular from 0.5 to 2.5 W/cm² and most particularly from 0.5 to 1.5 W/cm² of surface area of the target.

8. Process according to any one of claims 1 to 7, **characterised in that** said target comprises at least one compound having the formula AM₄S₈ wherein:
- A represents Ga or Ge;
- M represents V, Nb, Ta or Mo;
in particular at least one compound having the formula GaV₄S₈.

## Patentansprüche

1. Verfahren zur Herstellung eines dünnen Films mindestens einer Verbindung nach der Formel AM₄X₈, in der:
- A für Ga oder Ge steht;
- M für V, Nb, Ta oder Mo steht und
- X für S oder Se steht,
wobei dieses Verfahren die folgenden Schritte umfasst:
i) einen Schritt der Bildung eines dünnen Films mindestens einer Verbindung nach der Formel AM₄X₈ durch Magnetronsputtern eines Targets mit mindestens einer Verbindung nach der Formel AM₄X₈ in einer mindestens ein Inertgas enthaltenden Atmosphäre, und
ii) einen Schritt des Glühens des in Schritt i) gebildeten dünnen Films durch Wärmebehandlung,
bei dem Schritt i) und/oder Schritt ii) in Gegenwart von Schwefel durchgeführt werden, wenn X für S steht, oder in Gegenwart von Selen, wenn X für Se steht.

2. Verfahren nach Anspruch 1, **dadurch gekennzeichnet, dass** Schritt i) und/oder der Schritt ii) in einer Atmosphäre durchgeführt werden, die mindestens einen gasförmigen Vorläuferstoff von Schwefel enthält, wenn X für S steht, oder in einer Atmosphäre, die mindestens einen gasförmigen Vorläuferstoff von Selen enthält, wenn X für Se steht.

3. Verfahren nach Anspruch 1, **dadurch gekennzeichnet, dass** Schritt i) und/oder Schritt ii) durchgeführt werden:
- unter einem Strom eines gasförmigen Vorläuferstoffs von Schwefel oder in einer schwefelgesättigten Atmosphäre, wenn X für S steht, oder
- unter einem Strom eines gasförmigen Vorläuferstoffs von Selen oder in einer selengesättigten Atmosphäre, wenn X für Se steht.

4. Verfahren nach einem beliebigen der Ansprüche 1 bis 3, **dadurch gekennzeichnet, dass** Schritt ii) bei einer Temperatur zwischen 200 und 850°C, insbesondere zwischen 400 und 750°C und speziell zwischen 450 und 650°C durchgeführt wird.

5. Verfahren nach einem beliebigen der Ansprüche 1 bis 4, **dadurch gekennzeichnet, dass** Schritt ii) während einer Zeitdauer zwischen 1 Minute und 200 Stunden, insbesondere zwischen 10 Minuten und 48 Stunden und speziell zwischen 30 Minuten und 120 Minuten durchgeführt wird.

6. Verfahren nach einem beliebigen der Ansprüche 1 bis 5, **dadurch gekennzeichnet, dass** Schritt i) in einer Atmosphäre durchgeführt wird, deren Gesamtgasdruck zwischen 133 und 13300 mPa (1 und 100 mTorr), insbesondere zwischen 1330 und 10700 mPa (10 und 80 mTorr) und speziell zwischen 5330 et 8000 mPa (40 und 60 mTorr) beträgt.

7. Verfahren nach einem beliebigen der Ansprüche 1 bis 6, **dadurch gekennzeichnet, dass** Schritt i) in Gegenwart eines Stromerzeugers durchgeführt wird, der eine Leistung zwischen 0,1 mW/cm² und 20 W/cm², insbesondere zwischen 0,5 und 2,5 W/cm² und speziell zwischen 0,5 und 1,5 W/cm² der Fläche des Targets abgibt.

8. Verfahren nach einem beliebigen der Ansprüche 1 bis 7, **dadurch gekennzeichnet, dass** das Target mindestens eine Verbindung nach der Formel AM₄X₈ umfasst, in der:
- A für Ga oder Ge steht,
- M für V, Nb, Ta oder Mo steht,
insbesondere mindestens eine Verbindung nach der Formel GaV₄S₈.
